# EUROPÄISCHE PATENTSCHRIFT

(11) **EP 0 624 262 B1**
(45) Veröffentlichungstag und Bekanntmachung des Hinweises auf die Patenterteilung: **06.05.1998**
(21) Anmeldenummer: 92919329.0
(22) Anmeldetag: 10.09.1992
(51) Int. Cl.: G03F 7/16, G03F 7/075, H01L 21/312

(54) **VERFAHREN ZUM AUFBRINGEN EINER UV- UND/ODER ELEKTRONENSTRAHLEMPFINDLICHEN LACKSCHICHT**
METHOD OF APPLYING A LACQUER FILM SENSITIVE TO UV AND/OR ELECTRON-BEAM RADIATION
PROCEDE POUR L'APPLICATION D'UNE COUCHE DE VERNIS SENSIBLE AUX RAYONS ULTRAVIOLETS ET/OU AUX FAISCEAUX D'ELECTRONS

(30) Priorität: 30.01.1992 DE 4202652
(43) Veröffentlichungstag der Anmeldung: 17.11.1994
(73) Patentinhaber: FRAUNHOFER-GESELLSCHAFT ZUR FÖRDERUNG DER ANGEWANDTEN FORSCHUNG E.V., 80636 München (DE)
(72) Erfinder: KLUMPP, Armin, D-8000 München 2 (DE); HACKER, Erwin, Dipl.-Ing., D-86700 Kaufbeuren (DE)
(74) Vertreter: Schoppe, Fritz, Dipl.-Ing.
(86) Internationale Anmeldenummer: DE9200777
(87) Internationale Veröffentlichungsnummer: WO9315443

(56) Entgegenhaltungen:
- EP-A- 0 136 421
- EP-A- 0 382 932
- DE-C- 4 018 449
- US-A- 4 460 436

## Beschreibung

Die vorliegende Erfindung betrifft ein Verfahren zum Aufbringen einer UV- und/oder elektronenstrahlempfindlichen Lackschicht auf ein zu maskierendes Substrat.

Allgemein befaßt sich die Erfindung mit dem Aufbringen einer Lackschicht, die als Maske für die Lithographie bei der Herstellung elektronischer Schaltkreise mit hoher Packungsdichte verwendbar ist.

Mit zunehmender Erhöhung der Packungsdichte elektronischer Schaltkreise steigen die Anforderungen an die Lithographie an. Je kleiner die Strukturabmessungen werden, umso kritischer wird die Fokustiefe der Abbildung. Es ist bekannt, topographische Höhenunterschiede der IC-Oberfläche vor der Belichtung auszugleichen. Hierzu wird unter anderem eine sogenannte Zweilagentechnik angewendet.

Bei dieser Technik wird zunächst eine untere Schicht, die auch als Bottom Resist bezeichnet wird, in einer planarisierenden Spin-on- Technik auf die IC-Oberfläche aufgebracht. Diese untere Schicht besteht aus einer Kohlenstoffverbindung, die resistent gegenüber Fluor- oder Chlorchemie ist und die keine Fotoempfindlichkeit aufweist. Durch diese Planarisierungsschicht liegt die Unebenheit der sich ergebenden Oberfläche nun innerhalb der Fokustiefe der Abbildung. Nun kann die UV- bzw. elektronenstrahlempfindliche obere Lackschicht aufgebracht werden, die auch als Top Resist bezeichnet wird. Dies geschieht bei bekannten Verfahren der soeben beschriebenen Art ausschließlich mit der Spinon-Technik. Die obere Schicht dient nach der Belichtung durch ultraviolettes Licht oder durch einen Elektronenstrahl und nach ihrer Entwicklung als Maske für den Bottom Resist.

Daher muß der Top Resist gegenüber O₂-RIE (Reactive Ion Etch) beständig sein und sollte neben den reaktiven funktionellen Gruppen einen möglichst großen Anteil an Silizium bzw. Siliziumdioxid enthalten.

Die obere Lackschicht bzw. der Top-Resist-Lack wird bislang in aufwendigen Verfahrensschritten präpariert und in dem bekannten Schleuderverfahren, d.h. der sogenannten Spin-on-Technik, als dünne Polymerschicht auf die Waferoberfläche aufgebracht. Je nach dem gewünschten Einsatzbereich bezüglich der Belichtungswellenlänge und der Empfindlichkeit werden in die bekannten Top-Resist-Lacke für das Schleuderverfahren folgende funktionelle Gruppen mit eingebaut:

Ethoxy (-OC₂H₅), Hydroxy (-OH) mit Katalysator, Vinyl (-CH = CH₂), Chloromethyl (-CH₂CI), Phenylallyl, Chloromethylphenethyl sowie Si-Me.

Die Vorbereitung, Herstellung und Verarbeitung im Schleuderverfahren sowie teilweise auch die Untersuchung der Belichtungs- und Maskeneigenschaften ist in folgenden Schriften geoffenbart:
Novel Si-Containing Resist, Y. Yamashita, M. Kaziwara, J. Electrochem. Soc., Band 137, Nr. 10, Okt. 1990, Seiten 3253 bis 3257;
Submicron Pattern Transfer with New Designed E⁻ - Beam Resist and Bias-ECR Etcher, S. Sogito, S. Ishida, Y. Iida, Microelectronic Engineering 9, 1989, Seiten 533 bis 536;
Polysiloxanes with Pendant Cinnamoyl Groups as a negative Deep UV Resist for Bilayer Applications, C. Rosilis, A. Rosilio and B. Serre-Monanda, J. Electrochem, Soc., Band 136, Nr. 8, Aug. 1989, Seiten 2350 bis 2354;
A Comparison for the E-Beam Sensitivitites and Relative O₂-Plasma Stabilities of Organosilicon Polymers, E. Babich et al., Microelectronic Engineering 9, 1989, Seiten 537 bis 542; und

Novel Process for Direct Delineation of Spin on Glass (SOG), A. Imai et. al., Jap. J. of Appl. Physics, Band 29, November 1990, Seite 2653.

In viele Prozesse läßt sich das Aufbringen des Top-Resist-Lackes in dem Schleuderverfahren nicht integrieren. So ist beispielsweise das Schleuderverfahren bzw. die Spin-on-Technik nicht cluster-tool-tauglich. Unter dem cluster-tool versteht man im Bereich der Halbleitertechnologie eine Anlage, die anstelle einer Vielzahl von in einem Reinraum angeordneten separaten Einheiten ein zentrales Handhabungsgerät innerhalb eines in der Anlage gebildeten Vakuumbereiches hat, dem die Wafer durch eine Schleuse in einer Ladebox zugeführt werden können, woraufhin das zentrale Handhabungsgerät die Wafer entsprechend der durchzuführenden Prozesse einer Mehrzahl von Bearbeitungsstationen bzw. tools zuführt. Cluster- tool-taugliche Verfahren dürfen keine Naßprozesse umfassen und dürfen nicht in der Umgebungsatmosphäre stattfinden.

Ausgehend von diesem Stand der Technik liegt der vorliegenden Erfindung die Aufgabe zugrunde, ein Verfahren zum Aufbringen einer UV- und/oder elektronenstrahlempfindlichen Lackschicht auf ein zu maskierendes Substrat anzugeben, welches einen weiteren Anwendungsbereich hat.

Diese Aufgabe wird durch ein Verfahren gemäß Patentanspruch 1 gelöst.

Das erfindungsgemäße Verfahren sieht eine Abscheidung der UV- und/oder elektronenstrahlempfindlichen Lackschicht aus der Gasphase auf das Substrat vor. Hierzu werden eine Vinyl-haltige Substanz und ein Siloxan verdampft und aus der Gasphase auf dem Substrat abgeschieden.

Besonders bevorzugt sind erfindungsgemäß Trivinylmethylsilan (TVMS) als Lieferant der Vinylgruppen und Oktamethylcyclotetrasiloxan (OMCTS) als Silizium- bzw. SiO₂-Quelle.

Bevorzugte Weiterbildungen des erfindungsgemäßen Verfahrens sind in den Unteransprüchen angegeben.

Nachfolgend werden unter Bezugnahme auf die beiliegenden Zeichnungen bevorzugte Ausführungsformen des erfindungsgemäßen Verfahrens näher erläutert. Es zeigen:
- Fig. 1: Abscheidungsraten für die Abscheidung der UV- und/ oder elektronenstrahlempfindlichen Lackschicht in Abhängigkeit von Leistung, Druck und Fluß;
- Fig. 2: Konzentrationsverläufe von Vinylgruppen und SiH-Gruppen in Abhängigkeit von Leistung, Druck und Fluß;
- Fig. 3: eine IR-Spektroskopie einer Schicht aus TVMS; und
- Fig. 4: eine IR-Spektroskopie einer Schicht aus TVMS/OMCTS.

Bei einem bevorzugten Ausführungsbeispiel des erfindungsgemäßen Verfahrens werden zunächst die zu verdampfenden Substanzen, nämlich Oktamethylcyclotetrasiloxan und Trivinylmethylsilan (OMCTS und TVMS) mittels Flüssigkeitsmassenflußreglern dosiert und verdampft.

Dann werden die Substanzen über eine Ausströmdusche gleichmäßig in einen Reaktionsraum eingebracht, wofür keine weiteren Reaktions- oder Transportgase erforderlich sind. In dem Reaktionsraum findet die Reaktion der Substanzen in einem HF-Feld einer Parallelplattenanlage bei 13,5 MHz statt.

Depositionsergebnisse können in einem weiten HF-Leistungs- und Druckbereich erzielt werden. Typische Leistungsdichten reichen von 0,06 W/cm² bis 0,6 W/cm².

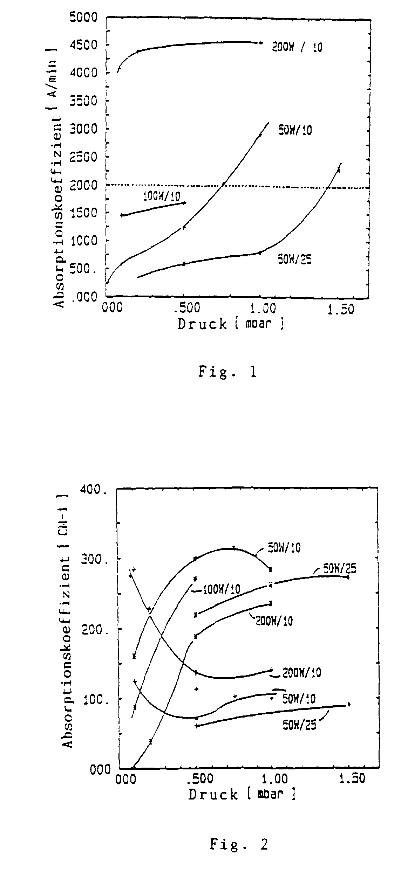

Erfindungsgemäß liegt der Druckbereich zwischen 0,3 mbar und 1,5 mbar. Wie in Fig. 1 gezeigt ist, werden Abscheideraten von 500 bis 5000 A/min gemessen. Die Substrattemperaturen liegen im Bereich zwischen 20°C und 90°C.

Interessant sind solche Bedingungen, bei denen eine große Konzentration von Vinylgruppen in der Schicht erhalten bleibt.

Fig. 2 zeigt die Ergebnisse einer kombinierten Auswertung mittels IR-Spektroskopie und Ellipsometrie. Absorptionskoeffizienten, die größer als 250 cm⁻¹ sind, bezeichnen eine belichtungsfähige Top-Resist-Schicht. Diejenigen Abscheidebedingungen, denen Absorptionskoeffizienten von mehr als 250 cm⁻¹ entsprechen, werden als geeignet angesehen.

In den Fig. 1 und 2 sind die Abscheideraten bzw. die Absorptionskoeffizienten in Abhängigkeit vom Druck mit folgenden Werten für die HF-Leistung und den Fluß als Parameter angegegeben: 50 W/10 sccm, 100 W/10 sccm, 200 W/10 sccm, 50 W/25 sccm.

Bei der verwendeten Parallelplattenanlage entspricht eine Gesamtleistung von 100 W einer Leistungsdichte von 0,318 W/cm².

In der Fig. 2 ist die Konzentration der Vinylgruppen jeweils mit einem (*) und diejenige der SiH-Gruppen jeweils mit einem (+) angegeben.

Die UV-Empfindlichkeit bzw. Elektronenstrahlempfindlichkeit wurde mittels IR-Spektroskopie und Naßentwicklung nachgewiesen.

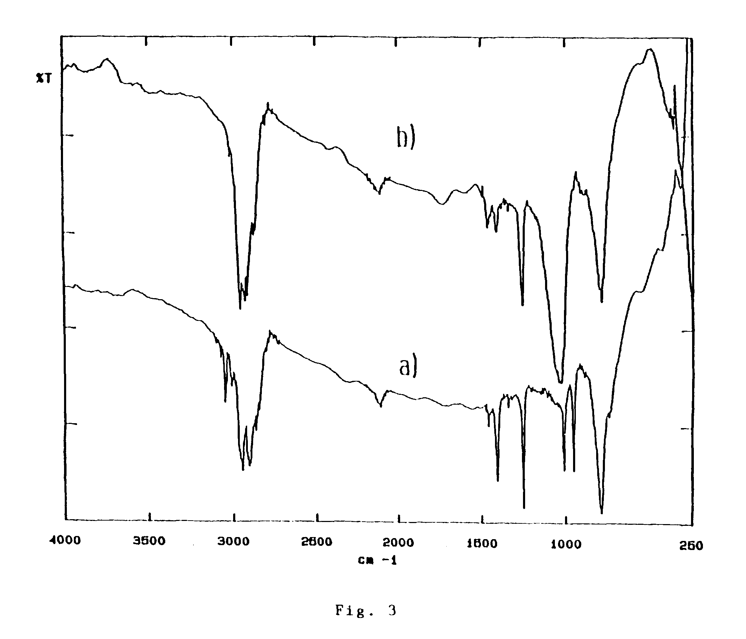

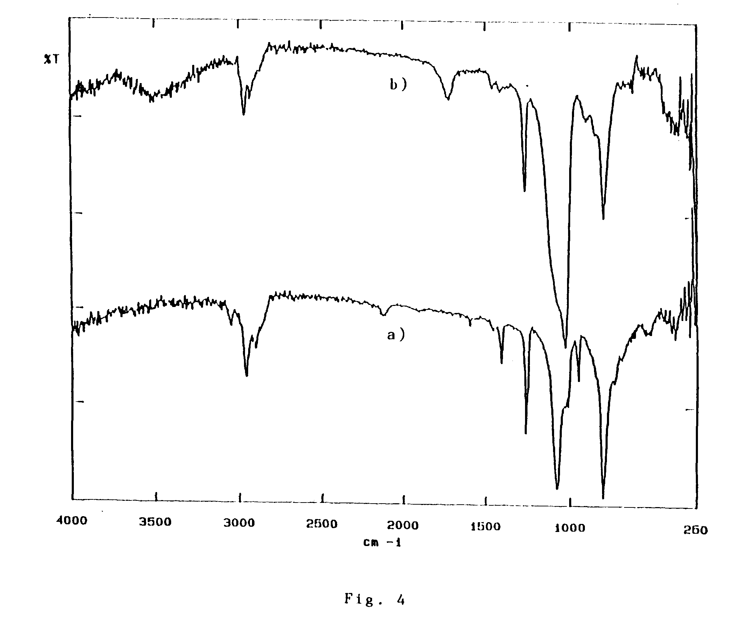

Die Fig. 3 und 4 zeigen sowohl Schichten aus TVMS als auch aus TVMS/OMCTS vor und nach der Belichtung mit UV- Licht. Hierbei bezeichnen jeweils die Kurven (a) Meßkurven der IR-Spektroskopie nach der Abscheidung und jeweils die Kurven (b) Meßkurven der IR-Spektroskopie nach der UV-Belichtung mit einer Wellenlänge von weniger als 200 nm.

In Fig. 3 können die Spitzenwerte bei den Wellenzahlen 3052, 1406, 1010 und 956 cm⁻¹ Vinylgruppen zugeordnet werden. Spitzenwerte bei 1252 und 805 cm⁻¹ entsprechen SiCH₃-Schwingungen. Nach der Belichtung sind die Vinylspitzenwerte verschwunden. Statt dessen weist ein neu hinzugekommener, großer Spitzenwert bei 1038 cm⁻¹ auf eine zusätzliche Vernetzung von Si-Atomen über Kohlenstoffketten hin.

Vergleicht man Fig. 4 mit Fig. 3, so erkennt man, daß die Spitzenwerte der Vinylgruppen und für Si-CH₃ ebenso wie bei der Kurve (a) in Fig. 3 liegen. Durch die Anwesenheit von Siloxanringen aufgrund von OMCTS tauchen weitere Spitzenwerte bei 1078 cm⁻¹ (Si-O-Si-stretching) und bei 1261 cm⁻¹ (Si-CH₃) auf. Auch hier verschwinden nach der Belichtung die Vinylspitzenwerte und es erscheint der Spitzenwert bei 1038 cm⁻¹. Die Siloxanringe scheinen hierdurch nicht beeinflußt zu werden.

Die chemischen Änderungen in der Schicht lassen sich anhand der Vinylspitzenwerte bei 3052, 1594, 1406, 1010 und 956 cm⁻¹ nachweisen. Nach der Belichtung sind diese Spitzenwerte verschwunden und es ist statt deren ein großer Spitzenwert bei 1040 cm⁻¹ entstanden, der auf eine zusätzliche Vernetzung von Si-Atomen über -CH₂- oder -CH₂CH₂-Bindungen hinweist. Die belichteten Bereiche sind in organischen Lösungsmitteln unlöslich.

Damit liefert die Erfindung einen Top-Resist-Lack, der im interessierenden Anregungswellenlängenbereich für Wellenlängen von ≤ 200 nm empfindlich ist und durch direktes Abscheiden aus der Gasphase aufgebracht werden kann.

Das erfindungsgemäße Verfahren ist cluster-tool-tauglich und eignet sich zur Integration in verschiedene Halbleiterprozesse.

## Patentansprüche

1. Verfahren zum Aufbringen einer UV- und/oder elektronenstrahlempfindlichen Lackschicht auf ein zu maskierendes Substrat, gekennzeichnet durch folgende Verfahrensschritte:
- Verdampfen einer Vinyl-haltigen Substanz und eines linearen oder zyklischen Siloxanes; und
- Abscheiden dieser Substanzen aus der Gasphase auf das zu maskierende Substrat.

2. Verfahren nach Anspruch 1, dadurch gekennzeichnet, daß das Siloxan Oktamethylcyclotetrasiloxan ist.

3. Verfahren nach Anspruch 1 oder 2, dadurch gekennzeichnet,
daß die Vinyl-haltige Substanz Trivinylmethylsilan ist.

4. Verfahren nach einem der Ansprüche 1 bis 3, gekennzeichnet durch folgende Verfahrensschritte:
- Dosieren der Substanzen mittels Flüssigkeitsmassendurchflußreglern;
- Verdampfen der Substanzen;
- verteiltes Einbringen der verdampften Substanzen in einen Reaktionsraum mittels einer Ausströmdusche; und
- Reaktion der Substanzen in einem HF-Feld.

5. Verfahren nach einem der Ansprüche 1 bis 4, dadurch gekennzeichnet,
daß das Abscheiden der Substanzen aus der Gasphase bei einem Druck von 0,3 bis 1,5 mbar durchgeführt wird.

6. Verfahren nach einem der Ansprüche 1 bis 5, dadurch gekennzeichnet, daß die Reaktion bei einer HF-Leistungsdichte von 0,06 bis 0,6 W/cm² durchgeführt wird.

7. Verfahren nach einem der Ansprüche 1 bis 6, dadurch gekennzeichnet,
daß die Substrattemperatur zwischen 20 und 90°C beträgt.

## Claims

1. A method of applying a lacquer film which is sensitive to UV and/or electron beam radiation to a substrate to be masked, characterized by the following method steps:
- vaporizing a vinyl-containing substance and a linear or cyclic siloxane; and
- depositing these substances from the gas phase onto the substrate to be masked.

2. A method according to claim 1, characterized in
that the siloxane is octamethylcyclotetrasiloxane.

3. A method according to claim 1 or 2, characterized in
that the vinyl-containing substance is trivinylmethylsilane.

4. A method according to one of the claims 1 to 3, characterized by the following method steps:
- dosing the substances with the aid of liquid mass flow control means;
- vaporizing the substances;
- distributed introduction of the vaporized substances in a reaction chamber by means of a discharge shower; and
- reaction of the substances in an HF field.

5. A method according to one of the claims 1 to 4,, characterized in
that deposition of the substances from the gas phase is carried out at a pressure of 0.3 to 1.5 mbar.

6. A method according to one of the claims 1 to 5, characterized in
that the reaction is carried out at an HF power density of from 0.06 to 0.6 W/cm².

7. A method according to one of the claims 1 to 6, characterized in
that the temperature of the substrate is between 20 and 90°C.

## Revendications

1. Procédé pour déposer une couche de vernis sensible aux UV et/ou aux faisceaux d'électrons sur un substrat qu'il s'agit de masquer, caractérisé par les phases de procédé suivantes :
- évaporation d'une substance contenant du vinyle et d'un siloxane linéaire ou cyclique ; et
- précipitation de ces substances sur le substrat à masquer à partir de la phase gazeuse.

2. Procédé selon la revendication 1, caractérisé en ce que le siloxane est l'octaméthylcyclotétrasiloxane.

3. Procédé selon la revendication 1 ou 2, caractérisé en ce que la substance contenant du vinyle est le trivinylméthylsilane.

4. Procédé selon une des revendications 1 à 3, caractérisé par les phases de procédé suivante :
- dosage des substances au moyen d'organes de réglage du débit massique de liquide ;
- évaporation des substances ;
- introduction répartie des substances évaporées dans une chambre de réaction au moyen d'une douche diffuseuse ; et
- réaction des substances dans un champ HF.

5. Procédé selon une des revendications 1 à 4, Caractérisé
en ce que la précipitation des substances à partir de la phase gazeuse est exécutée à une pression de 0,3 à 1,5 mbar.

6. Procédé selon une des revendications 1 à 5, caractérisé en ce que la réaction est exécutée à une densité de puissance HF de 0,06 à 0,6 W/cm².

7. Procédé selon une des revendications 1 à 6, caractérisé
en ce que la température du substrat est comprise entre 20° et 90°C.
